# EUROPEAN PATENT SPECIFICATION

(11) **EP 4 027 431 B1**
(45) Date of publication and mention of the grant of the patent: **18.03.2026**
(21) Application number: 20860622.8
(22) Date of filing: 03.09.2020
(51) Int. Cl.: H01M 10/44, H01M 10/48, H02J 7/02, H02J 7/04, G01R 31/389, G01R 31/392, H02J 7/00

(54) **POWER STORAGE SYSTEM, POWER STORAGE DEVICE, AND CHARGING METHOD**
STROMSPEICHERSYSTEM, STROMSPEICHERVORRICHTUNG UND LADEVERFAHREN
SYSTÈME ET DISPOSITIF DE STOCKAGE D'ÉNERGIE, ET PROCÉDÉ DE CHARGE

(30) Priority: 06.09.2019 JP 2019163040
(43) Date of publication of application: 13.07.2022
(73) Proprietor: Nuvoton Technology Corporation Japan, Nagaokakyo-shi, Kyoto 617-8520 (JP)
(72) Inventor: KOBAYASHI, Hitoshi, Nagaokakyo City, Kyoto 617-8520 (JP)
(74) Representative: Vigand, Philippe
(86) International application number: PCT/JP2020/033506
(87) International publication number: WO 2021/045172

(56) References cited:
- WO-A1-2017/159031
- JP-A- 2007 024 687
- JP-A- 2007 024 687
- JP-A- 2011 229 317
- JP-A- 2012 205 383
- JP-A- 2018 019 594
- JP-A- 2018 147 827
- JP-A- 2019 117 180
- US-A1- 2015 288 213
- US-A1- 2018 034 283
- US-A1- 2019 036 373

## Description

### [Technical Field]

The present disclosure relates to a power storage system, a power storage device, and a charging method.

### [Background Art]

Vehicles that run on rechargeable batteries, such as hybrid electric vehicles (HEVs) or electric vehicles (EVs), are being developed. One known technique for using rechargeable batteries safely is a battery management system (BMS) which estimates remaining charge and detects abnormalities.

For example, Patent Literature (PTL) 1 discloses a battery state determination device capable of diagnosing the capacity and amount of deterioration of a battery by measuring the complex impedance of the battery.

PTL 2 discloses a capacity maintenance ratio determination device capable of determining a capacity maintenance ratio without fully charging or discharging the battery.

PTL 3 discloses a vehicle controller that programs charging and discharging of a battery using parameters of an RC circuit model corresponding to the impedance of the battery.

PTL 4 and PTL 5 disclose a power storage system reflecting the preamble of present claim 1.

PTL 6 and PTL 7 show further prior art.

### [Citation List]

### [Patent Literature]

[PTL 1] Japanese Unexamined Patent Application Publication No. 2015-94726
[PTL 2] Japanese Unexamined Patent Application Publication No. 2011-38857
[PTL 3] U.S. Patent No. 10,023,064
[PTL 4] US 2015/288213
[PTL 5] US 2019/036373
[PTL 6] JP 2007 024687
[PTL 7] US 2018/034283

### [Summary of Invention]

### [Technical Problem]

Unfortunately, it is difficult to optimize the charging time of a power storage device with the conventional techniques. For example, when quick charging a power storage device, it is desirable to shorten the charging time by optimizing the charging current.

The present disclosure provides a power storage system, a power storage device, and a charging method that facilitates optimization of the charging time.

### [Solution to Problem]

A power storage system according to one aspect of the present invention is defined in the appended claims and includes: a cell stack including a plurality of power storage cells connected in series; a charging circuit that supplies a charging current to the cell stack; an alternating current excitating circuit that excitates the charging current using an alternating current; a complex impedance measuring unit that measures a current value of the alternating current used to excitate the charging current and a voltage value of each of the plurality of power storage cells, and measures a complex impedance of each of the plurality of power storage cells from the measured current value and the measured voltage value; and a charging control unit that controls the charging current based on the complex impedance, wherein, based on the complex impedance, the charging control unit is configured to optimize the charging current according to deterioration information that indicates an extent of deterioration of each of the plurality of power storage cells and is obtained from an external server device.

A charging method according to one aspect of the present invention is defined in the appended claims andis a method of charging a power storage device including a cell stack of a plurality of power storage cells connected in series, and includes: excitating a charging current to be supplied to the cell stack using an alternating current; measuring a current value of the alternating current used to excitate the charging current and a voltage value of each of the plurality of power storage cells; measuring a complex impedance of each of the plurality of power storage cells from the measured current value and the measured voltage value; and based on the complex impedance, optimizing the charging current according to deterioration information that indicates an extent of deterioration of each of the plurality of power storage cells and is obtained from an external server device.

### [Advantageous Effects of Invention]

According to one aspect of the present disclosure, the power storage system, the power storage device, and the charging method can facilitate optimization of the charging time.

### [Brief Description of Drawings]

[FIG. 1]

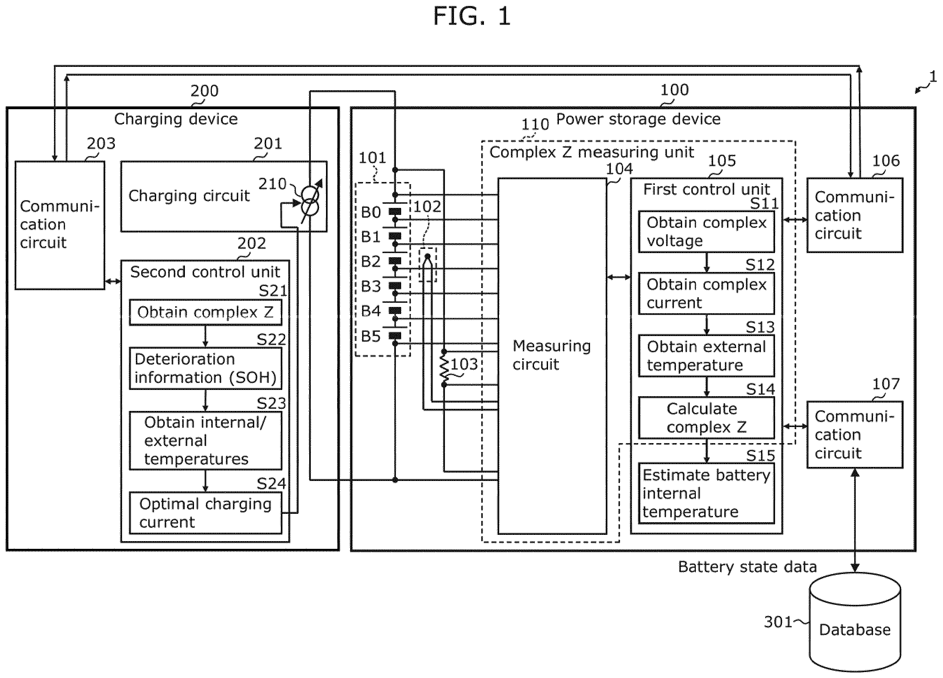

   FIG. 1 is a block diagram illustrating a configuration example of a power storage system according to Embodiment 1.
[FIG. 2]

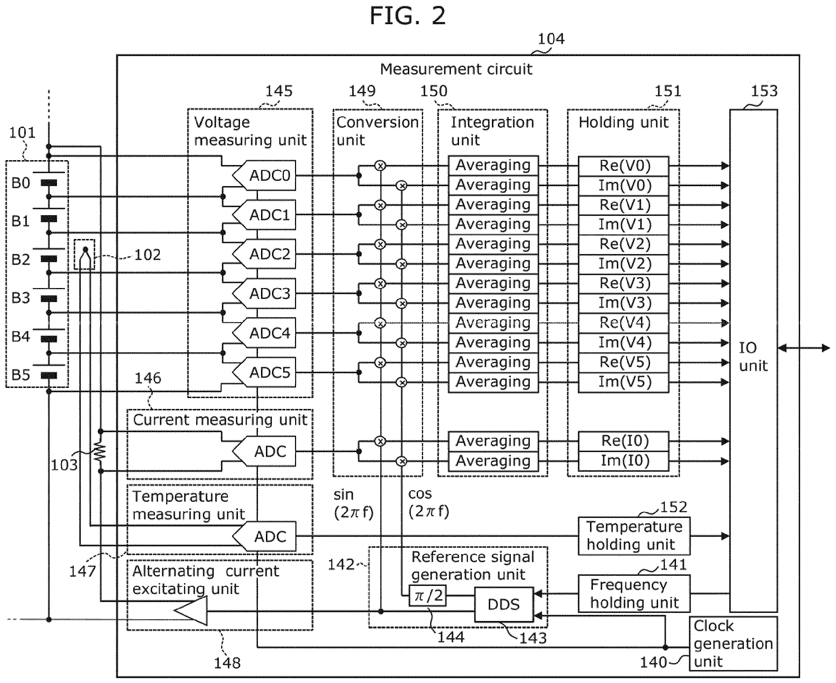

   FIG. 2 is a circuit diagram illustrating a detailed configuration example of a measuring circuit in the power storage system illustrated FIG. 1, and the surrounding circuitry.
[FIG. 3]

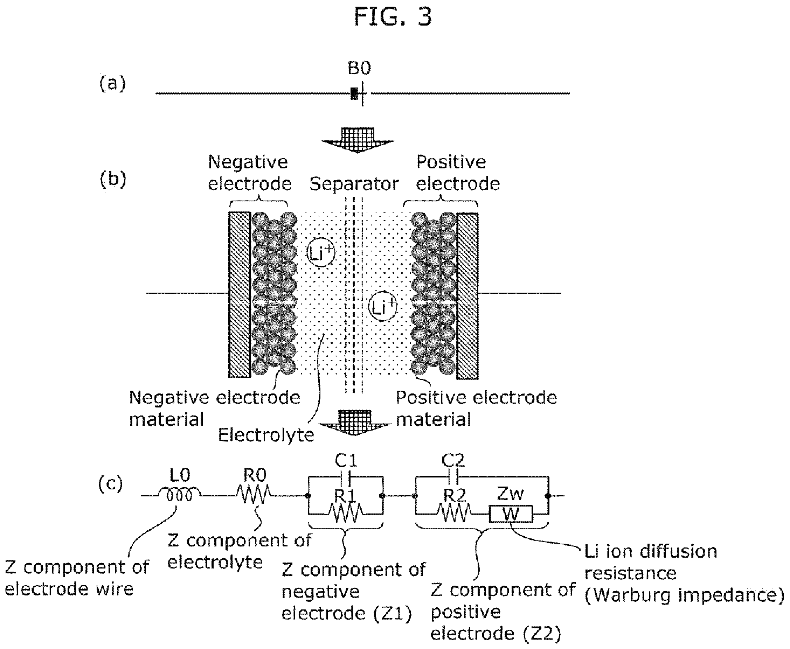

   FIG. 3 illustrates a structure example of a power storage cell and an example of an equivalent circuit model according to Embodiment 1.
[FIG. 4]

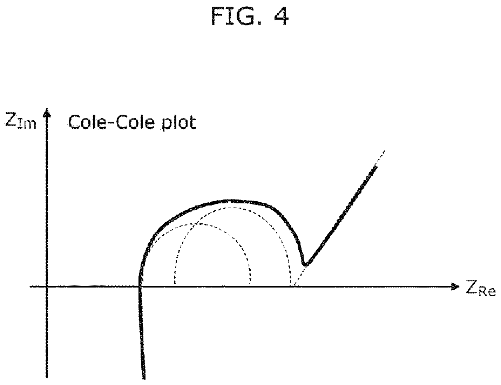

   FIG. 4 is a Cole-Cole plot illustrating an example of the complex impedance of a power storage cell according to Embodiment 1.
[FIG. 5]

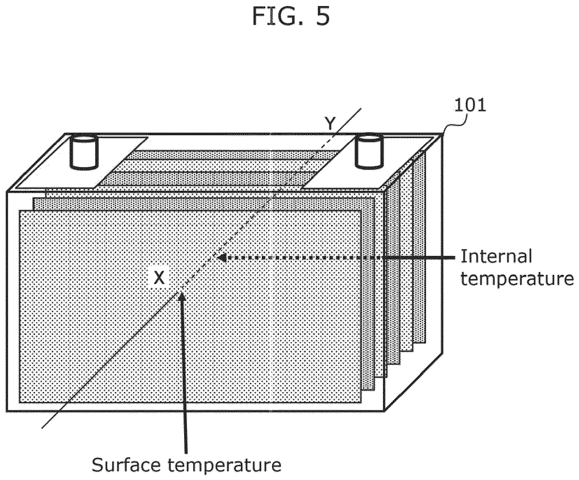

   FIG. 5 illustrates specific locations of measurement of the surface temperature and the internal temperature of a battery pack, which is given as one example of a cell stack, according to Embodiment 1.
[FIG. 6]

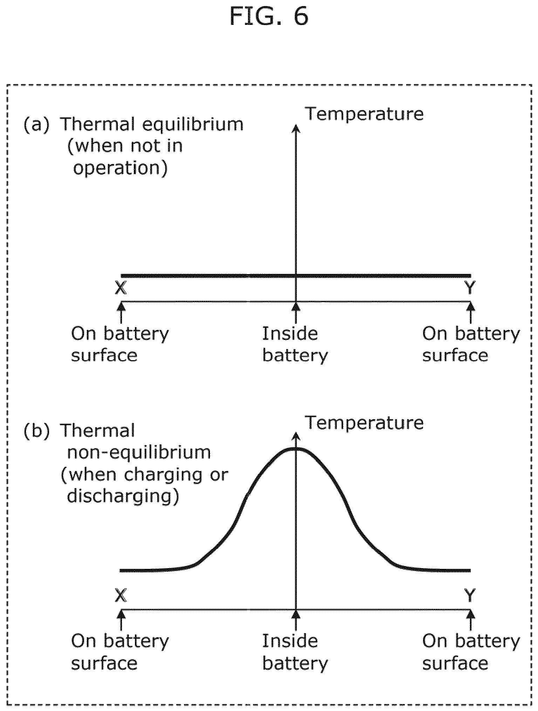

   FIG. 6 illustrates the difference between the surface temperature and the internal temperature of a battery pack, which is given as one example of a cell stack, according to Embodiment 1.
[FIG. 7]

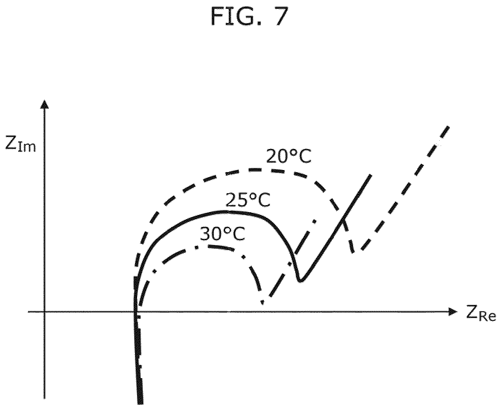

   FIG. 7 illustrates an example of the temperature dependence of the complex impedance of a power storage cell according to Embodiment 1.
[FIG. 8]

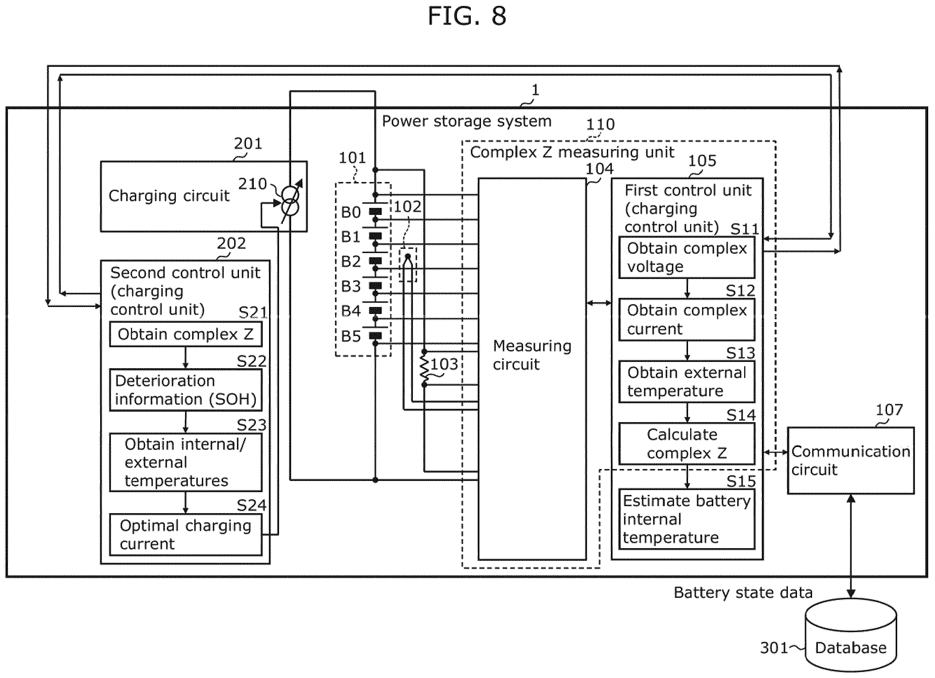

   FIG. 8 is a block diagram illustrating another configuration example of the power storage system according to Embodiment 1.
[FIG. 9]

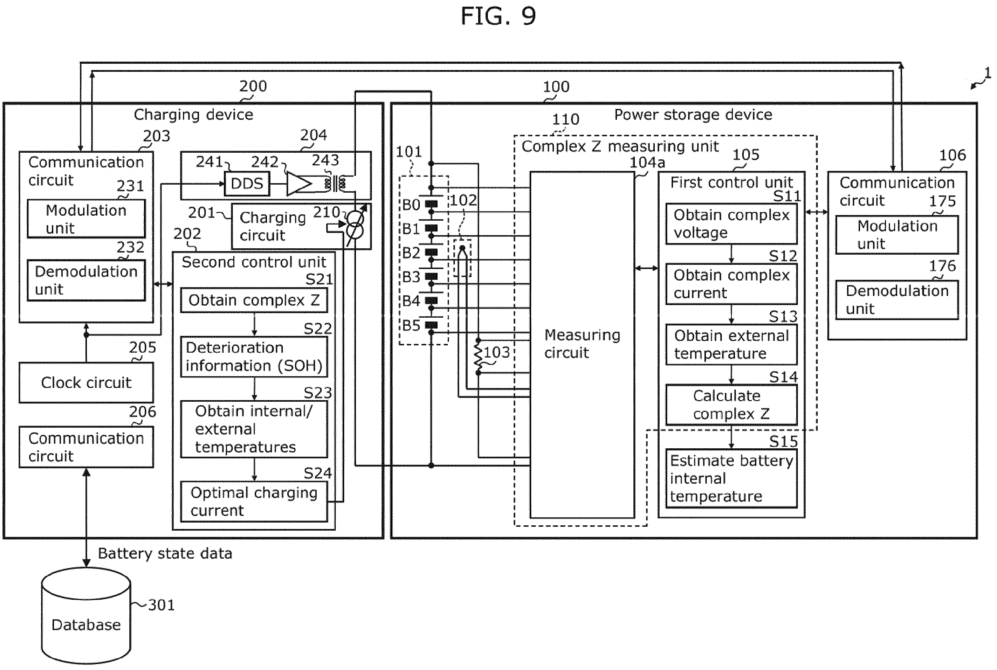

   FIG. 9 is a block diagram illustrating a configuration example of a power storage system according to Embodiment 2.
[FIG. 10]

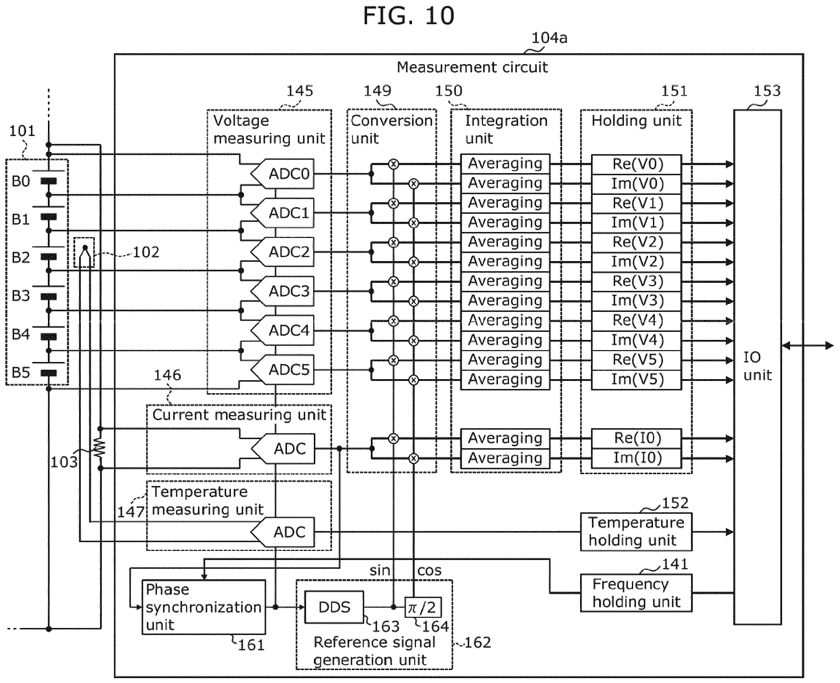

   FIG. 10 is a circuit diagram illustrating a detailed configuration example of a measuring circuit in the power storage system illustrated FIG. 9, and the surrounding circuitry.
[FIG. 11]

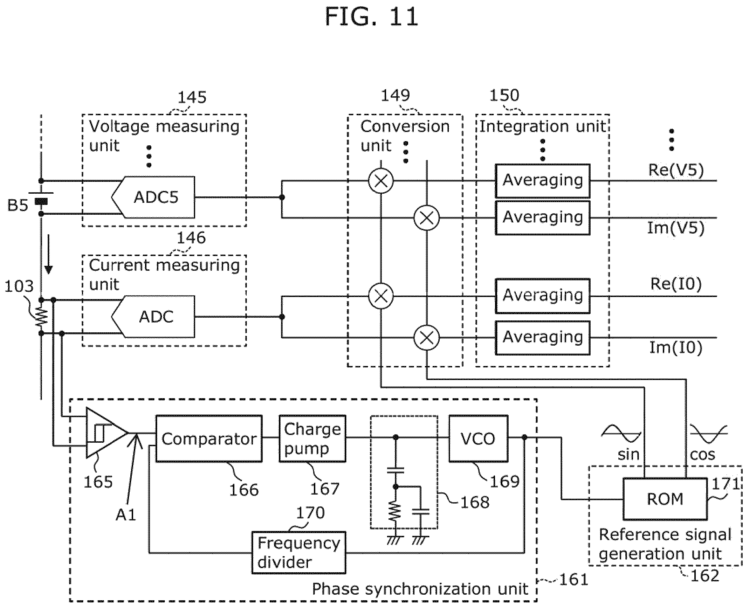

   FIG. 11 illustrates a detailed configuration example of the phase synchronization unit illustrated in FIG. 10, and an example of surrounding circuitry.
[FIG. 12]

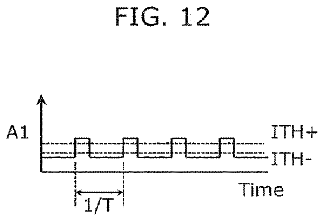

   FIG. 12 illustrates an output waveform example of the hysteresis circuit in FIG. 11.
[FIG. 13]

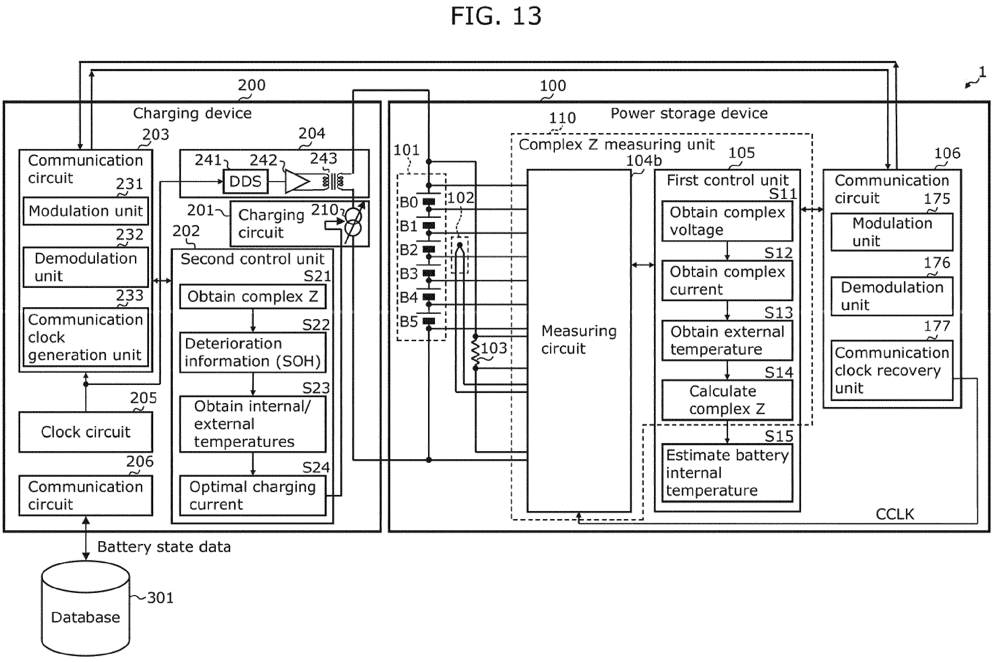

   FIG. 13 is a block diagram illustrating a configuration example of a power storage system according to Embodiment 3.
[FIG. 14]

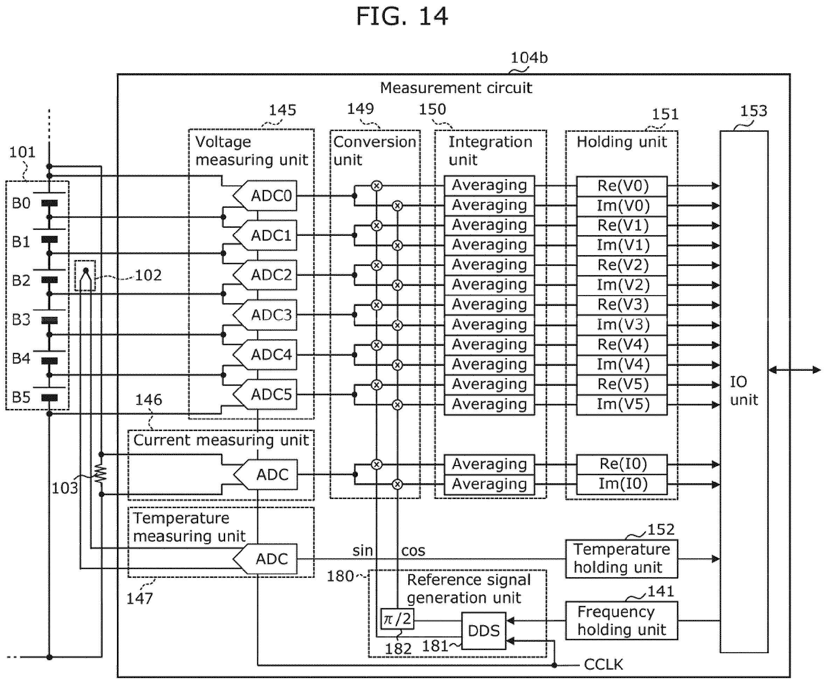

   FIG. 14 is a circuit diagram illustrating a detailed configuration example of a measuring circuit in the power storage system illustrated FIG. 13, and the surrounding circuitry.
[FIG. 15]

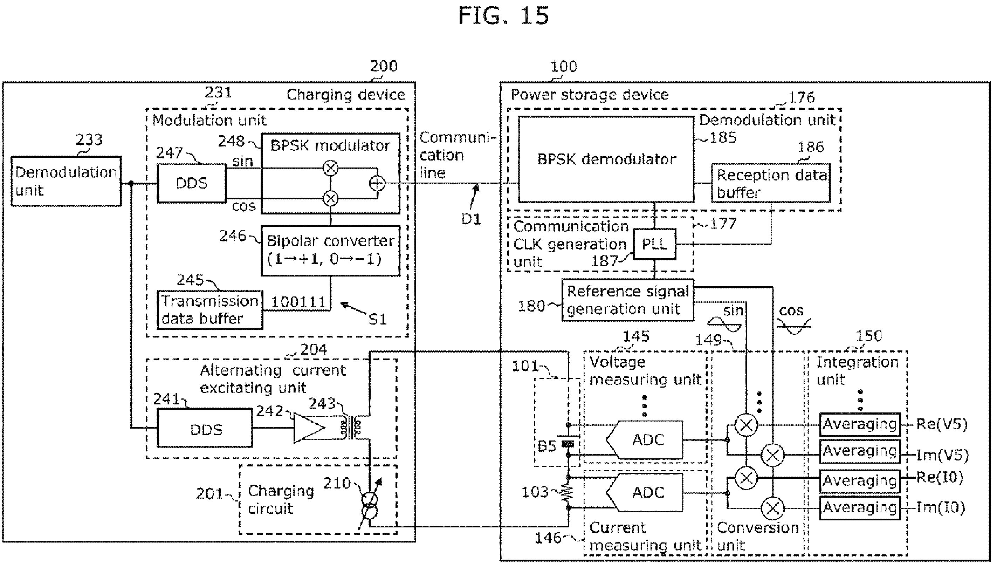

   FIG. 15 is a block diagram illustrating the configuration that is related to the alternating current frequency information in the power storage system illustrated in FIG. 13 in greater detail.
[FIG. 16]

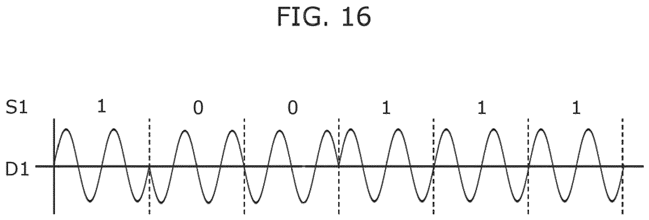

   FIG. 16 illustrates transmission data and a BPSK modulated waveform example from FIG. 15.
[FIG. 17A]

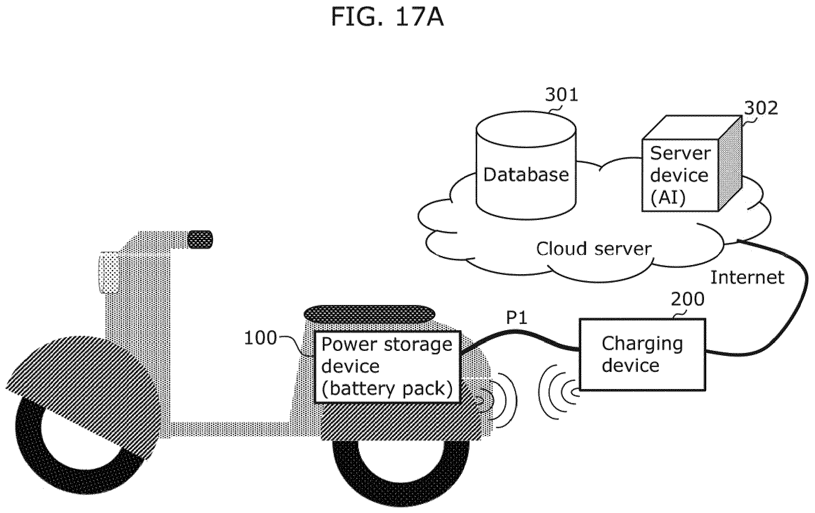

   FIG. 17A is a schematic diagram illustrating a first application example of the power storage system according to Embodiments 1 to 3.
[FIG. 17B]

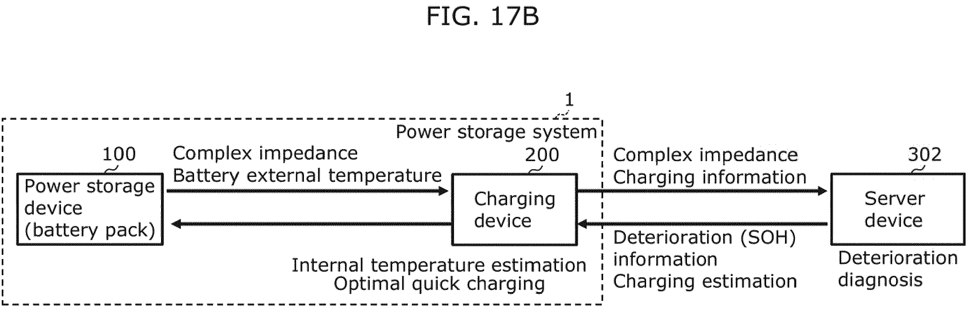

   FIG. 17B is a block diagram illustrating the first application example illustrated in FIG. 17A.
[FIG. 18]

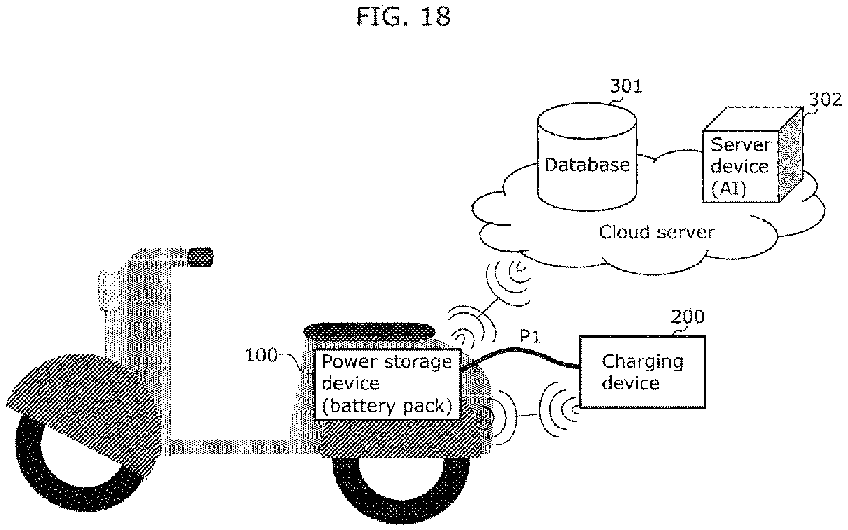

   FIG. 18 is a schematic diagram illustrating a second application example of the power storage system according to Embodiments 1 to 3.
[FIG. 19A]

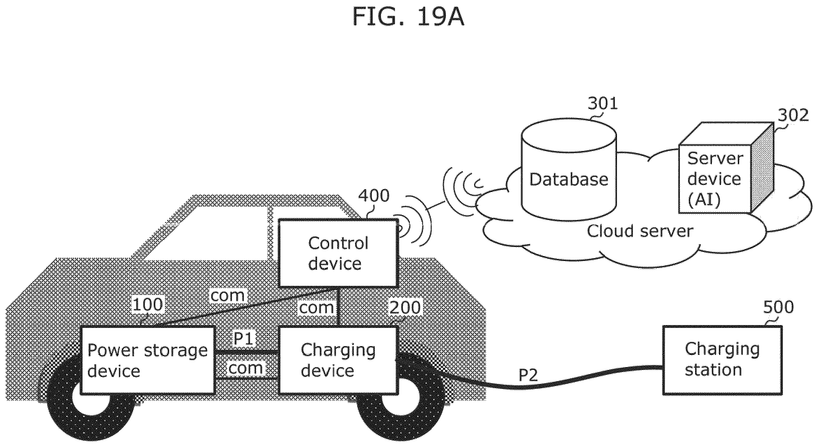

   FIG. 19A is a schematic diagram illustrating a third application example of the power storage system according to Embodiments 1 to 3.
[FIG. 19B]

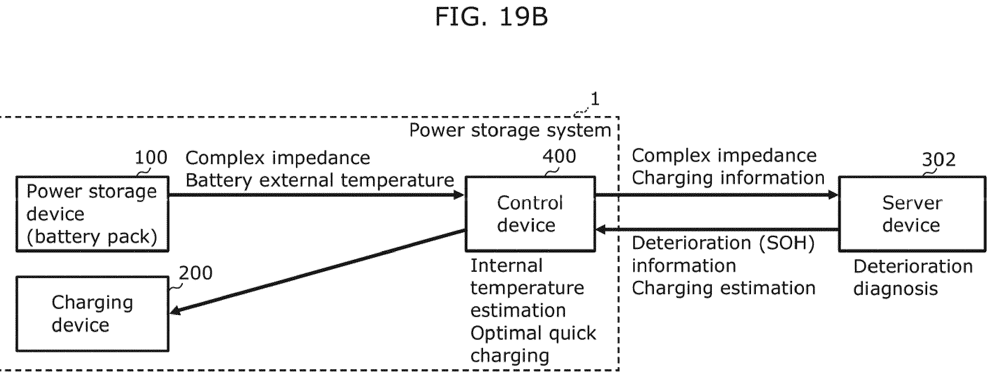

   FIG. 19B is a block diagram illustrating the third application example illustrated in FIG. 19A.

### [Description of Embodiments]

Hereinafter, embodiments are described with reference to the drawings. Each of the following embodiments describes a general or specific example. The numerical values, shapes, materials, elements, the arrangement and connection of the elements, steps, order of the steps, etc., shown in the following embodiments are mere examples, and therefore do not limit the present disclosure. Moreover, the embodiments of the present disclosure are not limited to the current independent claims, and may be expressed by other independent claims.

Note that the figures are schematic drawings, and are not necessarily exact depictions. In the figures, elements that are essentially the same share like reference signs, and duplicate description thereof is omitted or simplified.

### [Embodiment 1]

### [1.1 Configuration of Power Storage System 1]

First, the configuration of power storage system 1 according to Embodiment 1 will be described.

FIG. 1 is a block diagram illustrating a configuration example of power storage system 1 according to Embodiment 1. FIG. 1 also illustrates external database 301.

Power storage system 1 illustrated in FIG. 1 includes power storage device 100 and charging device 200. Power storage device 100 includes cell stack 101, thermistor 102, current sense resistor 103, measuring circuit 104, first control unit 105, communication circuit 106, and communication circuit 107. Charging device 200 includes charging circuit 201, second control unit 202, and communication circuit 203.

Measuring circuit 104 and the sections corresponding to S11 to S14 of first control unit 105 are collectively referred to as complex impedance measuring unit 110. The section corresponding to S15 of first control unit 105 and second control unit 202 are collectively referred to as a charging control unit.

Power storage device 100 includes a rechargeable battery, and, for example, is provided in a vehicle and supplies electric power to a motor serving as a power source.

Cell stack 101 is a rechargeable battery and includes a plurality of power storage cells B0 to B5 connected in series. Each power storage cell is, for example, a lithium ion battery, but may be another type of battery such as a nickel metal hydride battery. Each power storage cell may moreover be a series-connected power storage cell such as a lithium ion capacitor. Cell stack 101 is connected to a load and a charging circuit. For example, the load is, but not limited to, the motor of an HEV or an EV. Although cell stack 101 is exemplified as including six power storage cells in FIG. 1, the number of power storage cells in cell stack 101 is not limited to six.

Thermistor 102 is a temperature sensor whose resistance value changes depending on temperature. Thermistor 102 is attached to the surface of cell stack 101, and is used to measure the external temperature of cell stack 101. For example, thermistor 102 is attached near the central region of the side surface of cell stack 101.

Current sense resistor 103 is a resistive element for sensing, as a voltage drop, the alternating current value used to excitate the charging current flowing through cell stack 101.

Complex impedance measuring unit 110 measures the current value of the alternating current used to excitate the charging current flowing through cell stack 101 and the voltage value of each power storage cell B0 to B5, and measures the complex impedance of each power storage cell B0 to B5 from the measured current value and the measured voltage value. It is for this reason that complex impedance measuring unit 110 includes measurement circuit 104 and the sections corresponding to S11 to S14 of first control unit 105.

Measurement circuit 104 measures the current value of the alternating current used to excitate the charging current flowing through cell stack 101 and the voltage value of each of the power storage cells (B0 to B5). The measured current value and the measured voltage value are complex current and complex voltage including phase information relative to the alternating current used to excitate the charging current. Measurement circuit 104 further measures the external temperature of cell stack 101 using thermistor 102.

First control unit 105 is a micro controller/computer unit (MCU) including a central processing unit (CPU), memory, and an input/output (I/O) circuit, and performs the following processes by executing a program in the memory. The memory of first control unit 105 stores, for example, a program for repeatedly executing the processes shown in S11 to S15 of FIG. 1. More specifically, first control unit 105 obtains the complex voltage of each power storage cell B0 to B5 from measurement circuit 104 (S11). First control unit 105 further obtains a complex current as a current value of the alternating current used to excitate the charging current (S12). First control unit 105 also obtains an external temperature of cell stack 101 (S13). First control unit 105 further calculates the complex impedance of each power storage cell B0 to B5 by dividing the obtained complex voltages by the complex current (S14). In this way, first control unit 105 receives the measurement results of measurement circuit 104 and handles part of the complex impedance measurement.

First control unit 105 further estimates the internal temperature of cell stack 101 as a part of the processes for charging control (S15). In other words, first control unit 105 estimates the internal temperature of cell stack 101 based on the obtained external temperature and the complex impedance of each power storage cell B0 to B5. For example, first control unit 105 may estimate the internal temperature using temperature characteristic data indicating a correspondence between the internal temperature of cell stack 101 and the complex impedance, and temperature distribution data indicating a distribution of the external temperature and the internal temperature of the cell stack. The temperature characteristic data and the temperature distribution data may be held in the memory of first control unit 105 in advance, and, alternatively, may be obtained from database 301 via communication circuit 107 and temporarily held in the memory. First control unit 105 repeatedly executes the above steps S11 to S15 during charging of cell stack 101 by charging device 200. This repetition is a period that can be detected by sufficiently following the rate of change at which the internal temperature of cell stack 101 rises due to the heat generated by the charging current.

Communication circuit 106 communicates with communication circuit 203 in charging device 200 under control of first control unit 105. For example, communication circuit 106 transmits the complex impedance of each power storage cell B0 to B5, the external temperature of cell stack 101, and the estimated internal temperature to charging device 200.

Communication circuit 107 communicates with external database 301. Database 301 is a database for collecting and providing battery state data on power storage cells B0 to B5 of cell stack 101 and battery state data about the power storage cells in other power storage devices. The battery state data includes, for example, deterioration information called state of health (SOH).

Charging device 200 is a device for charging cell stack 101, and controls the charging current sent to cell stack 101 based on the complex impedance transmitted from power storage device 100, the external temperature of cell stack 101, and the internal temperature.

Communication circuit 203 communicates with communication circuit 106 in power storage device 100 under control of second control unit 202. For example, communication circuit 203 receives the complex impedance of each power storage cell B0 to B5, the external temperature of cell stack 101, and the estimated internal temperature from power storage device 100.

Charging circuit 201 includes variable current source 210. Variable current source 210 supplies a charging current to cell stack 101 under control of second control unit 202.

Second control unit 202 is an MCU including a CPU, a memory, and an I/O circuit, and executes a program in the memory. The memory of second control unit 202 stores, for example, a program for repeatedly executing the processes shown in S21 to S24 of FIG. 1. Second control unit 202 repeatedly executes the processes shown in S21 to S24 during charging of cell stack 101.

First, second control unit 202 obtains the complex impedance of each power storage cell B0 to B5 from power storage device 100 via communication circuit 203 (S21), and further obtains the deterioration information (i.e., the SOH) from database 301 via power storage device 100 and communication circuit 203 (S22). At this time, second control unit 202 may obtain the remaining charge of each power storage cell B0 to B5 from first control unit 105 via communication circuit 106 and communication circuit 203. The remaining charge is also referred to as the state of charge (SOC). Second control unit 202 further obtains the estimated internal temperature of each power storage cell B0 to B5 and the measured external temperature from power storage device 100 via communication circuit 203 (S23). Communication circuit 203 determines an optimum charging current based on the complex impedances, the deterioration information, the internal temperatures, and the external temperature (S24), and controls variable current source 210 to supply the determined optimum charging current to cell stack 101.

Regarding the optimum charging current for quick charging, for example, second control unit 202 determines the value of the charging current so as to shorten the charging time as much as possible until the charge level of cell stack 101 reaches a predetermined level, within a range that does not cause the internal temperature to exceed a threshold value. The predetermined level may be any value, for example, 80% charge, 90% charge, full charge, etc.

### [1.2 Configuration of Measurement Circuit 104]

Next, a detailed configuration example of measurement circuit 104 in complex impedance measuring unit 110 will be described.

FIG. 2 is a circuit diagram illustrating a detailed configuration example of measurement circuit 104 in power storage system 1 illustrated FIG. 1, and the surrounding circuitry.

Measurement circuit 104 illustrated in FIG. 2 includes clock generation unit 140, frequency holding unit 141, reference signal generation unit 142, voltage measuring unit 145, current measuring unit 146, temperature measuring unit 147, alternating current excitating unit 148, conversion unit 149, integration unit 150, holding unit 151, temperature holding unit 152, and IO unit 153.

Clock generation unit 140 generates a sampling clock signal. The sampling clock signal is supplied to an analog-to-digital converter (ADC) in voltage measuring unit 145, an ADC in current measuring unit 146, and an ADC in temperature measuring unit 147.

Frequency holding unit 141 holds the frequency instructed from outside power storage device 100. This frequency refers to the frequency of a reference frequency signal of reference signal generation unit 142.

Reference signal generation unit 142 generates a reference frequency signal and a quadrature reference frequency signal having the frequency held in frequency holding unit 141. For this purpose, reference signal generation unit 142 includes DDS 143 and phase shifter 144.

DDS 143 is an abbreviation for direct digital synthesizer, which includes a ROM that holds waveform data sampled from a sine wave, inputs an address that points to the sampling point, and outputs the data (i.e., the sample value) of the sampling point of the sine wave. Since the address changes continuously, the output sample value is an almost continuous sine wave.

Phase shifter 144 shifts the phase of the reference frequency signal by 90 degrees to generate a quadrature reference frequency signal. Reference signal generation unit 142 may be configured to generate both the reference frequency signal and the quadrature frequency signal with a single DDS 143, without phase shifter 144.

Voltage measuring unit 145 measures the voltage of cell stack 101 by sampling the voltage of cell stack 101 using the sampling clock signal from clock generation unit 140. More specifically, voltage measuring unit 145 includes the same number of analog-to-digital converters (ADCO to ADC5) corresponding to power storage cells B0 to B5 in cell stack 101. Each analog-to-digital converter samples the voltage of a corresponding power storage cell among the plurality of power storage cells B0 to B5 using the sampling clock signal from clock generation unit 140, and converts the sampled voltage into a digital signal.

Current measuring unit 146 measures the alternating current used to excitate the charging current flowing through cell stack 101 by sampling the current of cell stack 101 using the sampling clock signal from clock generation unit 140. The alternating current used to excitate the charging current is measured as a voltage drop across current sense resistor 103 inserted in a current loop path through which the alternating current applied by alternating current excitating unit 148 flows. The voltage drop is proportional to the alternating current used to excitate the charging current, so the voltage drop means the alternating current value. More specifically, current measuring unit 146 includes an analog-to-digital converter (ADC) for measuring the current of cell stack 101, which is a rechargeable battery. This analog-to-digital converter samples the voltage drop across current sense resistor 103 using the sampling clock signal from clock generation unit 140, and converts the sampled voltage drop into a digital signal. Since current measuring unit 146 and voltage measuring unit 145 use the same sampling clock, the measurement can be made with high accuracy.

Temperature measuring unit 147 measures the external temperature of cell stack 101 using thermistor 102 included in cell stack 101. Thermistor 102 may be, for example, a temperature sensor using a thermocouple or some other element. More specifically, temperature measuring unit 147 includes an analog-to-digital converter (ADC). This analog-to-digital converter (ADC) samples the voltage of thermistor 102 and converts the sampled voltage to a digital value.

Alternating current excitating unit 148 excitates the charging current flowing through cell stack 101 using an alternating current having a frequency component of the reference frequency signal generated in reference signal generation unit 142. Alternating current excitating unit 148 includes a differential buffer that applies the reference frequency signal as a differential signal to the positive and negative electrodes of cell stack 101.

Conversion unit 149 multiplies the measurement results of voltage measuring unit 145 and current measuring unit 146 by the reference frequency signal and the quadrature reference frequency signal. With this, conversion unit 149 converts the measurement results of voltage measuring unit 145 and current measuring unit 146 into real and imaginary part components of the complex voltage and the complex current. Accordingly, conversion unit 149 includes multiplier pairs respectively corresponding to the analog-to-digital converters (ADCO to ADC5) of voltage measuring unit 145 and a multiplier pair corresponding to the analog-to-digital converter of current measuring unit 146. Each multiplier pair corresponding to voltage measuring unit 145 includes a multiplier that multiplies the conversion result of the corresponding analog-to-digital converter (i.e., the sampled digital voltage value) by a reference frequency signal and a multiplier that multiplies that conversion result by a quadrature reference frequency signal. The result of the former multiplication indicates the real part component of the sampled voltage when it is expressed as a complex voltage. The result of the latter multiplication indicates the imaginary part component of the sampled voltage when it is expressed as a complex voltage. The multiplier pair corresponding to current measuring unit 146 includes a multiplier that multiplies the conversion result of the corresponding analog-to-digital converter (i.e., the sampled digital current value) by a reference frequency signal and a multiplier that multiplies that conversion result by a quadrature reference frequency signal. The result of the former multiplication indicates the real part component of the sampled current when it is expressed as a complex current. The result of the latter multiplication indicates the imaginary part component of the sampled current when it is expressed as a complex current.

Each of the analog-to-digital converters (ADCO to ADC5) can be, for example, a delta-sigma type AD converter. The analog-to-digital converters (ADCO to ADC5) may have the same AD conversion characteristics. The AD conversion characteristics refer to various parameters such as resolution (number of bits). Specifically, the same AD converter is used for the analog-to-digital converters (ADCO to ADC5). This reduces measurement error caused by AD conversion, which occurs between power storage cells B0 to B5.

Integration unit 150 averages the real and imaginary part components of the complex voltage and complex current, respectively, which are repeatedly measured by voltage measuring unit 145 and converted by conversion unit 149. This averaging can also make the measurement more accurate. More specifically, integration unit 150 includes averaging circuit pairs respectively corresponding to the multiplier pairs of conversion unit 149. Each averaging circuit pair includes an averaging circuit that averages the real part component of the complex voltage or complex current and an averaging circuit that averages the imaginary part component of the complex voltage or complex current. If the power storage cell is a lithium ion battery, the internal complex impedance is, for example, several mΩ. Assuming that the alternating current used to excitate the charging current is 1 A, the change in output voltage is only a few mV. On the other hand, since the DC output voltage of a lithium ion battery is roughly 3.4 V, measuring the voltage with an analog-to-digital converter connected to the power storage cell requires a dynamic range of 4 to 5 V. In this case, if the complex impedance measurement accuracy requires approximately 8 bits, an analog-to-digital converter with approximately 18 to 20 effective bits is required, but a high-resolution AD converter consumes more power and occupies more space. On the other hand, the internal complex impedance measured for electrochemical impedance analysis of lithium ion batteries is measured in the low frequency range of 0.01 Hz to several 10 KHz, which is almost near DC, so the measurement of complex voltage cannot be performed with AC connection. In the configuration of FIG. 1, the resolution can be increased by integration by repeatedly applying alternating current, separating the complex voltage and complex current into real and imaginary part components, and averaging them. Therefore, even an analog-to-digital converter with a small number of bits (for example, approximately 16 bits) can be used to obtain complex impedance measurement results with 20- to 24-bit accuracy. If the measurement accuracy of the complex voltage can be improved, the magnitude of the applied alternating current can be lowered, making it easier to measure large capacity, small internal complex impedance rechargeable batteries.

Holding unit 151 holds the real and imaginary components of the complex voltage and complex current after the averaging process. Accordingly, holding unit 151 includes the same number of resistor pairs as the plurality of power storage cells of cell stack 101 for holding the complex voltage, and a resistor pair for holding the complex current. Each resistor pair for holding the complex voltage includes a resistor (Re(Vi)) that holds the real part component of the complex voltage of the corresponding power storage cell Bi, and a resistor that holds the imaginary part component (Im(Vi)). Here, i is an integer between 0 and 5, inclusive. The resistor pair for holding the complex current includes a resistor (Re(I0)) that holds the real part component of the complex current of corresponding cell stack 101, and a resistor that holds the imaginary part component (Im(I0)).

Temperature holding unit 152 holds the digital values from temperature measuring unit 147 as temperature data.

IO unit 153 is an input/output circuit that outputs the complex impedance held in holding unit 151 to first control unit 105 and receives inputs of data indicating the frequency of the reference frequency signal from first control unit 105.

Measurement circuit 104 configured as described above can measure accurately because the phase error in the voltage measurement and the current measurement is almost zero.

### [1.3 Power Storage Cell Equivalent Circuit Model and Complex Impedance]

Next, an example of an equivalent circuit model of a power storage cell and its element constants will be given.

FIG. 3 illustrates a structure example of a power storage cell and an example of an equivalent circuit model according to an embodiment. In FIG. 3, (a) illustrates the circuit symbol for power storage cell B0. In FIG. 3, (b) schematically illustrates a structure example when power storage cell B0 is a lithium ion battery. Power storage cell B0 includes a negative electrode, a negative electrode material, an electrolyte, a separator, a positive electrode material, and a positive electrode, as a premise for the equivalent circuit model. In, FIG. 3, (c) illustrates one example of an equivalent circuit model of power storage cell B0. This equivalent circuit model includes inductive component L0, resistive components R0 to R2, capacitive components C1 and C2, and a lithium ion diffusion resistive component Zw. Inductive component L0 indicates the impedance component of the electrode wire. Resistive component R0 indicates the impedance component of the electrolyte. The parallel circuit of resistive component R1 and capacitive component C1 represents the impedance component of the negative electrode. The portion of the circuit consisting of resistive component R2, lithium ion diffusion resistive component Zw, and capacitive component C2 indicates the impedance component of the positive electrode. Lithium ion diffusion resistive component Zw is known as the Warburg impedance.

The state of power storage cell B0 can be estimated by calculating the element constants of each circuit element of the equivalent circuit model. For example, the deterioration state of power storage cell B0 can be estimated by the change in an element constant over time.

Next, an example of the characteristics of the complex impedance of a battery cell will be given.

FIG. 4 is a Cole-Cole plot illustrating an example of the complex impedance of a power storage cell according to Embodiment 1. A Cole-Cole plot is also called a complex plane diagram or Nyquist plot. FIG. 4 corresponds to the equivalent circuit model in (c) of FIG. 3. In the method of calculating the complex impedance of a power storage cell by using alternating current to excitate the charging current, it is generally known that an equivalent circuit with resistors and capacitors arranged in parallel is used when charge transfer rate-limiting is used, which forms a semicircle in the complex number plane. In addition, it is generally known that when this Warburg impedance is included, a straight line rising at 45 degrees diagonally from a location before the semicircle completes (near the upper right) as a Warburg impedance-derived slope is formed.

In the calculation of the complex impedance, the phase error of measurement system factors generally has a frequency characteristic, which is a problem when measuring the complex impedance at different frequencies. In particular, when the frequency is varied and the complex impedance of each frequency is drawn on the Cole-Cole plot, each frequency phase error is expressed as a quadrature error between the real (horizontal) and imaginary (vertical) axes on the complex plane of the Cole-Cole plot. This makes it difficult to draw an accurate Cole-Cole plot. However, with the configuration illustrated in FIG. 2, the complex voltage and complex current are measured before the complex impedance is calculated, which makes it possible to draw an accurate Cole-Cole plot with very small phase errors in the voltage and current measurement systems.

### [1.4 External Temperature and Internal Temperature]

Next, the difference between the external temperature and the internal temperature of cell stack 101 will be described. The internal temperature is an important parameter when quick charging cell stack 101. The charging current can be set within a range not exceeding the upper limit of the internal temperature. However, the internal temperature rises significantly as the charging current is increased. The upper limit of the charging current amount therefore differs depending on the internal temperature when quick charging cell stack 101.

FIG. 5 illustrates specific locations of measurement of the surface temperature and the internal temperature of a battery pack, which is given as one example of cell stack 101, according to Embodiment 1. Note that the battery pack may correspond to a single power storage cell instead of cell stack 101.

The battery pack in FIG. 5 schematically illustrates cell stack 101 housed in a battery case. The internal temperature is, for example, the temperature at the location of the three-dimensional center of gravity or center of the battery pack. The internal temperature itself cannot be measured directly by thermistor 102. The surface temperature (also referred to as the external temperature) is the temperature at the position of the X near the central region of the side surface of the battery pack. The surface temperature can be measured directly by attaching thermistor 102.

FIG. 6 illustrates the difference between the surface temperature and the internal temperature of a battery pack, which is given as one example of the cell stack, according to Embodiment 1. In (a) and (b) in FIG. 6, the horizontal axes indicate the axial direction passing vertically through the side surface of FIG. 5. "X" represents the intersection of the axis and the side surface in the front in FIG. 5. "Y" represents the intersection of the axis and the side surface in the back that is hidden from view. The vertical axes represent temperature.

FIG. 6 illustrates, in (a), a temperature distribution of the battery pack at thermal equilibrium. Thermal equilibrium refers to a state in which the temperature inside cell stack 101 is uniform when no current is flowing in cell stack 101, that is, when cell stack 101 is not being charged for a while and not supplying current is supplied for a while. Here, the internal temperature is the same as the surface temperature.

FIG. 6 illustrates, in (b), a temperature distribution of the battery pack at thermal non-equilibrium. Thermal non-equilibrium refers to when cell stack 101 is charging or discharging. In thermal non-equilibrium, the current flowing inside cell stack 101 generates heat, so the internal temperature is higher than the surface temperature. Temperature distribution data such as the data illustrated in (b) of FIG. 6 is useful for estimating the internal temperature based on the surface temperature. Although it is difficult to quantify the temperature distribution data, it is possible, however, to estimate the internal temperature using the surface temperature and complex impedance.

Next, the temperature dependence of the complex impedance will be described.

FIG. 7 illustrates an example of the temperature dependence of the complex impedance of a power storage cell according to Embodiment 1. FIG. 7 illustrates Cole-Cole plots for power storage cell temperatures of 20°C, 25°C, and 30°C. The estimation of the internal temperature from the complex impedance of the power storage cell thus utilizes a temperature dependence. Second control unit 202 can estimate the internal temperature by using such temperature characteristic data that shows a correspondence between the internal temperature and the complex impedance of cell stack 101.

With power storage system 1 according to the present embodiment, the charging current supplied to power storage device 100 can be optimized. Since the complex impedance measured in power storage device 100 corresponds to the internal temperature and deterioration state of power storage cells B0 to B5, second control unit 202 can determine a suitable charging current for cell stack 101. For example, when quick charging power storage device 100, the charging time can be shortened by optimizing the charging current.

### [1.5 Variation]

Although power storage system 1 is exemplified in FIG. 1 as having a configuration that is largely divided into power storage device 100 and charging device 200, the configuration of power storage system 1 is not limited to this example. For example, in power storage system 1, power storage device 100 and charging device 200 may be configured as a single unit, as illustrated in FIG. 8. In such cases, first control unit 105 and second control unit 202 may be integrated as a charging control unit (i.e., one MCU), and communication circuit 106 and communication circuit 203 may be omitted.

Power storage system 1 according to Embodiment 1 described above includes: cell stack 101 including a plurality of power storage cells B0 to B5 connected in series; charging circuit 201 that supplies a charging current to cell stack 101; alternating current excitating unit 148/204 that excitates the charging current using an alternating current; complex impedance measuring unit 110 that measures a current value of the alternating current used to excitate the charging current and a voltage value of each of the plurality of power storage cells B0 to B5, and measures a complex impedance of each of the plurality of power storage cells B0 to B5 from the measured current value and the measured voltage value; and a charging control unit (S15 + 202) that controls the charging current based on the complex impedance. Here, the charging control unit corresponds to a combination of S15 in first control unit 105 and second control unit 202.

This makes it easier to optimize the charging current of the power storage device. Since the complex impedance corresponds to the internal temperature and deterioration state of the power storage cell, the charging control unit can determine a charging current suitable for each individual power storage cell. For example, when quick charging the power storage device, the charging time can be shortened by optimizing the charging current.

The charging control unit may estimate an internal temperature of each of the plurality of power storage cells B0 to B5 based on an external temperature of cell stack 101 and the complex impedance, and optimize the charging current according to the estimated internal temperature.

This makes it possible to estimate the internal temperature from the complex impedance, and an optimum charging current can be determined under the estimated internal temperatures.

The charging control unit may estimate the internal temperature of each of the plurality of power storage cells according to at least one of temperature characteristic data or temperature distribution data, the temperature characteristic data indicating a correspondence between an internal temperature of the cell stack and the complex impedance, and the temperature distribution data indicating a distribution of the external temperature and the internal temperature of the cell stack.

This makes it possible to increase the accuracy of the estimation since at least one of the temperature characteristic data or the temperature distribution data is used to estimate the internal temperature.

The charging control unit may control the charging current according to a deterioration state of each of the plurality of power storage cells estimated from the complex impedance.

This makes it possible to optimize the charging current according to the deterioration state.

Based on the complex impedance, the charging control unit may optimize the charging current according to deterioration information that indicates an extent of deterioration of each of the plurality of power storage cells B0 to B5 and is obtained from external server device 302.

With this, the deterioration state can be estimated using an external server device, and the charging current can be optimized according to the estimated deterioration state.

The charging control unit may determine a value of the charging current to shorten a charging time required for a charge level of cell stack 101 to reach a predetermined level.

This makes quick charging possible.

The charging control unit may suspend charging when the internal temperature reaches a threshold.

This makes it possible to suspend charging when the internal temperature exceeds a threshold value.

The power storage system may include power storage device 100 and charging device 200. Power storage device 100 may include: cell stack 101; alternating current excitating unit 148; complex impedance measuring unit 110; and first communication circuit 106 that transmits information about the complex impedance to charging device 200. Charging device 200 may include: charging circuit 201; the charging control unit; and second communication circuit 203 that receives the information about the complex impedance from power storage device 100.

Power storage device 100 may include reference signal generation unit 180 that generates a reference frequency signal. Alternating current excitating unit 148 may generate the alternating current synchronized with the reference frequency signal, and complex impedance measuring unit 110 may measure the complex impedance using the reference frequency signal.

This makes it possible to make accurate measurements since the same reference frequency signal is used for voltage measurement and current measurement. It is moreover possible to make accurate measurements since the reference frequency signal is commonly used for the alternating current used to excitate the charging current, the voltage measurement, and the current measurement.

Power storage device 100 according to Embodiment 1 includes: cell stack 101 of a plurality of power storage cells B0 to B5 connected in series; alternating current excitating unit 148 that excitates a charging current to be supplied to cell stack 101 using an alternating current; complex impedance measuring unit 110 that measures a current value of the alternating current used to excitate the charging current and a voltage value of each of the plurality of power storage cells B0 to B5, and measures a complex impedance of each of the plurality of power storage cells B0 to B5 from the measured current value and the measured voltage value; and communication circuit 106 that notifies a charging device that supplies the charging current of the complex impedance.

This makes it easier to optimize the charging current of the power storage device. Since the complex impedance corresponds to the internal temperature and deterioration state of the power storage cell, the charging control unit can determine a charging current suitable for each individual power storage cell. For example, when quick charging the power storage device, the charging time can be shortened by optimizing the charging current.

A charging method according to Embodiment 1 is a method of charging power storage device 100 including a cell stack 101 of a plurality of power storage cells B0 to B5 connected in series, and includes: excitating a charging current to be supplied to cell stack 101 using an alternating current; measuring a current value of the alternating current used to excitate the charging current and a voltage value of each of the plurality of power storage cells B0 to B5; measuring a complex impedance of each of the plurality of power storage cells B0 to B5 from the measured current value and the measured voltage value; and controlling the charging current based on the complex impedance.

This makes it easier to optimize the charging current of the power storage device.

### [Embodiment 2]

In Embodiment 1, an example is given in which power storage device 100 excitates a charging current using an alternating current for complex impedance measurement. In contrast, Embodiment 2 describes an example in which the excitation of a charging current using an alternating current is performed by charging device 200.

### [2.1 Configuration of Power Storage System 1]

FIG. 9 is a block diagram illustrating a configuration example of a power storage system according to Embodiment 2. FIG. 9 differs from FIG. 1 mainly in that measurement circuit 104 is replaced with measurement circuit 104a, and alternating current excitating unit 204 and clock circuit 205 are added to charging device 200. The following description will focus on these differences.

Measurement circuit 104a differs from measurement circuit 104 illustrated in FIG. 1 mainly in that it generates a reference frequency signal synchronized with the alternating current used to excitate the charging current and uses this reference frequency signal to measure the complex voltage and complex current. With this, the measurement accuracy of the complex voltage and complex current can be as high as FIG. 1.

Clock circuit 205 generates an alternating current to be used to excitate the charging current and a reference frequency signal that serves as a reference for communication by communication circuit 203.

Communication circuit 203 includes modulation unit 231 and demodulation unit 232 that perform modulation and demodulation also using the reference frequency signal generated by clock circuit 205. Communication circuit 106 includes modulation unit 175 and demodulation unit 176 for the purpose of communicating with communication circuit 203.

Alternating current excitating unit 204 excitates the charging current flowing in cell stack 101 using an alternating current synchronized with the reference frequency signal generated by clock circuit 205. Alternating current excitating unit 204 thus includes DDS 241, driver 242, and transformer 243.

DDS 241 is an abbreviation for direct digital synthesizer, which includes a ROM that holds waveform data sampled from a sine wave of the alternating current to be used to excitate the charging current, inputs an address that points to the sampling point, and outputs the data (i.e., the sample value) of the sampling point of the sine wave. Since the address changes continuously, the output sample value indicates an almost continuous sine wave. The waveform of the alternating current to be used to excitate the charging current need not be sinusoidal, and may be a pulsed waveform.

Driver 242 is a differential buffer that outputs the sine wave output from DDS 241 to transformer 243 as a differential signal.

Transformer 243 excitates the charging current flowing in cell stack 101 using a differential signal indicating the alternating current from driver 242.

### [2.2 Configuration of Measurement Circuit 104a]

Next, a detailed configuration of measurement circuit 104a will be described.

FIG. 10 is a circuit diagram illustrating a detailed configuration example of measurement circuit 104a in power storage system 1 illustrated FIG. 9, and the surrounding circuitry. FIG. 10 differs from FIG. 2 in that frequency holding unit 141, reference signal generation unit 142, and alternating current excitating unit 148 are removed, and phase synchronization section 161 and reference signal generation unit 162 are added. The following description will focus on these differences.

Phase synchronization unit 161 generates a clock signal synchronized with the AD conversion result of current measuring unit 146, that is, the alternating current used to excitate the charging current. This clock signal has the frequency indicated by the frequency data held in frequency holding unit 141.

Reference signal generation unit 162 generates a reference frequency signal and a quadrature reference frequency signal synchronized with the clock signal from phase synchronization unit 161. For this purpose, reference signal generation unit 162 includes DDS 163 and phase shifter 164. DDS 163 and phase shifter 164 may be configured like DDS 143 and phase shifter 144 illustrated in FIG. 2.

### [2.3 Configuration of Phase Synchronization Unit 161]

Next, a more detailed configuration example of phase synchronization unit 161 will be described.

FIG. 11 illustrates a detailed configuration example of phase synchronization unit 161 illustrated in FIG. 10, and an example of surrounding circuitry. Note that phase synchronization unit 161 illustrated in FIG. 11 is a configuration example in which the AD conversion result of current measuring unit 146 is not synchronously detected, but the input signal to current measuring unit 146, that is, the alternating current value as a voltage drop of current sense resistor 103, is synchronously detected.

Phase synchronization unit 161 illustrated in FIG. 11 includes hysteresis circuit 165, comparator 166, charge pump 167, LPF 168, VCO 169, and frequency divider 170.

Hysteresis circuit 165 binarizes the alternating current value detected by current sense resistor 103. FIG. 12 illustrates the output waveform (A1) of hysteresis circuit 165 in FIG. 11. Time is represented on the horizontal axis and output voltage corresponding to the current value is represented on the vertical axis. ITH+ and ITH- are examples of the upper and lower threshold values of the hysteresis characteristic. The output waveform (A1) of hysteresis circuit 165 becomes a pulsed square wave as illustrated in FIG. 12 that has the same frequency 1/T as the alternating current signal used to excitate the charging current.

Comparator 166 compares the output signal from hysteresis circuit 165 with the frequency divider signal from frequency divider 170 to detect the phase difference.

Charge pump 167 raises the signal indicating the detected phase difference to the required voltage level.

LPF 168 is referred to as a low pass filter or loop filter, and smoothes the signal indicating the phase difference from charge pump 167.

VCO 169 is a voltage-controlled oscillator, and outputs a signal with a frequency corresponding to the voltage of the smoothed signal.

Frequency divider 170 divides the signal from VCO 169 and feeds it back to comparator 166.

With this configuration, phase synchronization unit 161 generates a frequency signal synchronized with the alternating current detected by current sense resistor 103.

Reference signal generation unit 162 generates a reference frequency signal and a quadrature frequency signal synchronized with the frequency signal from phase synchronization unit 161.

According to the configuration described above, even when it is charging device 200 that excitates the charging current using the alternating current, since the reference frequency signal and the quadrature frequency signal used by measurement circuit 104a are synchronized with the alternating current used to excitate the charging current, the complex impedance can be measured with high accuracy.

Power storage system 1 according to Embodiment 2 described above includes power storage device 100 and charging device 200. Power storage device 100 includes: cell stack 101; complex impedance measuring unit 110; and phase synchronization circuit 161 that generates a reference frequency signal synchronized with the alternating current used to excitate the charging current. Charging device 200 includes: alternating current excitating unit 148; charging circuit 201; and the charging control unit. Complex impedance measuring unit 110 measures the complex impedance using the reference frequency signal.

This makes it possible to measure the complex impedance with high accuracy.

### [Embodiment 3]

In the present embodiment, as in Embodiment 2, another example in which the excitation of the charging current using an alternating current is performed by charging device 200 for complex impedance measurement will be described. In Embodiment 2, an example is given in which a reference frequency signal synchronized with the alternating current is generated using phase synchronization unit 161 that synchronously detects the alternating current used to excitate the charging current in power storage device 100. In contrast, Embodiment 3 describes a configuration example in which a reference frequency signal is generated from alternating current frequency information about the frequency of the alternating current transmitted from charging device 200 to power storage device 100.

### [3.1 Configuration of Power Storage System 1]

FIG. 13 is a block diagram illustrating a configuration example of power storage system 1 according to Embodiment 3. FIG. 13 differs from the FIG. 9 according to Embodiment 2 mainly in that communication clock generation unit 233 is added in communication circuit 203, communication clock recovery unit 177 is added in communication circuit 106, and measurement circuit 104b is provided instead of measurement circuit 104a. The following description will focus on these differences.

Communication circuit 203 is the same as in Embodiment 2 in that it receives information about the complex impedance from communication circuit 106 of power storage device 100. Communication circuit 203 further transmits alternating current frequency information about the frequency of the alternating current used to excitate the charging current to communication circuit 106. Note that the communication line between communication circuit 203 and communication circuit 106 includes a communication signal line and does not include a communication clock signal line.

Communication clock generation unit 233 generates a communication clock signal synchronized with a reference frequency signal generated by clock circuit 205. Modulation unit 231 generates a communication signal that is the communication data modulated using the communication clock signal, and transmits the generated communication signal to communication circuit 106.

Communication circuit 106 is the same as in Embodiment 2 in that it transmits information about the complex impedance to charging device 200. Communication circuit 106 further receives the alternating current frequency information as a communication signal from communication circuit 203.

Communication clock recovery unit 177 recovers a communication clock signal from the communication signal received by communication circuit 106 and supplies it to demodulation unit 176. The recovered communication clock signal is referred to as CCLK. Demodulation unit 176 demodulates the communication signal using the recovered communication clock signal. Communication clock signal CCLK is also supplied to measurement circuit 104b. Measurement circuit 104b uses a reference frequency signal that is synchronized with communication clock signal CCLK.

Here, the alternating current frequency information corresponds to the data timing of the communication signal and the edge timing of the communication clock signal. For example, the alternating current frequency information is transmitted constantly, as needed, or repeatedly during the charging period, as a normal or specific communication signal.

Measurement circuit 104b measures the complex voltage and complex current using a reference frequency signal synchronized with communication clock signal CCLK recovered by communication clock recovery unit 177.

### [3.2 Configuration of Measurement Circuit 104b]

Next, a detailed configuration of measurement circuit 104b will be described.

FIG. 14 is a circuit diagram illustrating a detailed configuration example of measurement circuit 104b in power storage system 1 illustrated FIG. 13, and the surrounding circuitry. FIG. 14 differs from measurement circuit 104a illustrated in FIG. 10 according to Embodiment 2 mainly in that phase synchronization unit 161 is removed and reference signal generation unit 180 is provided instead of reference signal generation unit 162. The following description will focus on these differences.

Reference signal generation unit 180 generates a reference frequency signal that is synchronized with recovered communication clock signal CCLK. Reference signal generation unit 180 thus includes DDS 181 and phase shifter 182. DDS 181 and phase shifter 182 may be configured like DDS 163 and phase shifter 164.

### [3.3 Configuration of Communication Circuit]

Next, among the configurations of power storage system 1 according to the present embodiment, the main configurations related to the alternating current frequency information corresponding to the data timing of the communication signal and the edge timing of the communication clock signal will be described in more detail.

FIG. 15 is a block diagram illustrating the configuration that is related to the alternating current frequency information in power storage system 1 illustrated in FIG. 13 in greater detail.

FIG. 15 illustrates a configuration example in which modulation unit 231 performs binary phase shift keying (BPSK) modulation. For this reason, modulation unit 231 includes transmission data buffer 245, bipolar converter 246, DDS 247, and BPSK modulator 248.

Transmission data buffer 245 is a buffer register that temporarily holds the transmission data. In FIG. 15, transmission data S1 is exemplified as "100111".

Bipolar converter 246 converts the 1s and 0s of the transmission data to +1s and -1s.

DDS 247 generates a sine wave signal and a cosine wave signal synchronized with the communication clock signal generated in communication clock generation unit 233.

BPSK modulator 248 includes two multipliers and one adder. BPSK modulator 248 shifts by 180 degrees (i.e., inverts) the phase of the sine and cosine wave signals generated by DDS 247 when the bipolar converted transmission data is -1, and does not invert the phase of the sine and cosine wave signals generated by DDS 247 when the bipolar converted transmission data is 1. BPSK modulator 248 generates a communication signal as a sum of a non-inverted sine wave signal and a non-inverted cosine wave signal or as a sum of an inverted sine wave signal and an inverted cosine wave signal for each symbol of transmitted data (in this example, one symbol is one bit). FIG. 16 illustrates transmission data S1 and BPSK modulated waveform example D1 from FIG. 15. For the sake of explanation, only non-inverted or inverted sine wave signal components of waveform example D1 are shown.

Demodulation unit 176 illustrated in FIG. 15 includes BPSK demodulator 185 and reception data buffer 186.

BPSK demodulator 185 demodulates the communication data from the communication signal.

Reception data buffer 186 temporarily holds the demodulated communication data.

Communication clock recovery unit 177 includes PLL 187 and recovers a communication clock signal from the communication signal.

Reference signal generation unit 180 generates a reference frequency signal and a quadrature reference frequency signal that are synchronized with the recovered communication clock signal.

With such a circuit, power storage device 100 generates a reference frequency signal synchronized with the alternating current from the alternating current frequency information transmitted from charging device 200. Since measurement circuit 104b uses a reference frequency signal synchronized with the alternating current, the complex voltage and the complex current can be measured with high accuracy.

Power storage system 1 according to Embodiment 3 described above includes power storage device 100 and charging device 200. Power storage device 100 includes: cell stack 101; complex impedance measuring unit 110; first communication circuit 106 that transmits information about the complex impedance to charging device 200 and receives alternating current frequency information about a frequency of the alternating current; and a reference signal generation circuit that generates a reference frequency signal from the alternating current frequency information. Charging device 200 includes: alternating current excitating unit 148; charging circuit 201; the charging control unit; and second communication circuit 203 that receives the information about the complex impedance from power storage device 100 and transmits the alternating current frequency information. Complex impedance measuring unit 110 measures the complex impedance using the reference frequency signal.

With this, since measurement circuit 104b takes measurements using the reference frequency signal generated from the alternating current frequency information, the complex voltage and complex current can be measured with high accuracy.

Second communication circuit 203 may include communication clock generation unit 233 that generates a communication clock signal and modulation unit 231 that generates a communication signal that is communication data modulated using the communication clock signal. First communication circuit 106 may include communication clock recovery unit 177 that recovers the communication clock signal from the communication signal and demodulation unit 176 that demodulates the communication signal using the recovered communication clock signal. Alternating current excitating circuit 204 may generate the alternating current synchronized with the communication clock signal. Reference signal generation unit 180 may generate the reference frequency signal synchronized with the recovered communication clock signal. Complex impedance measuring unit 110 may measure the complex impedance using the reference frequency signal. The alternating current frequency information may correspond to a data timing of the communication signal and an edge timing of the communication clock signal.

With this, the data timing of the communication signal can be easily transmitted as alternating current frequency information. The alternating current frequency information also corresponds to the edge timing of the recovered communication clock signal.

Although the communication line connecting communication circuit 203 and communication circuit 106 according to Embodiment 3 is exemplified as including a communication signal line and not including a communication clock signal line, this example is non-limiting. The communication line may include both a communication signal line and a communication clock signal line. In such cases, communication clock recovery unit 177 is omitted.

Although a configuration example is described in which communication circuit 203 includes communication clock generation unit 233 and communication circuit 106 includes communication clock recovery unit 177 for the purpose of describing a case in which a communication signal is transmitted from communication circuit 203 to communication circuit 106 as alternating current frequency information, this configuration example is non-limiting. Each of communication circuit 203 and communication circuit 106 may include a communication clock generation unit and a communication clock recovery unit in order to perform bidirectional communication.

Moreover, the connection between communication circuit 203 and communication circuit 106 is not limited to a wired connection and may be a wireless connection.

### (Application Example)

Next, specific application examples of power storage system 1 according to Embodiments 1 to 3 will be given.

First, a first application example of power storage system 1 will be given.

FIG. 17A is a schematic diagram illustrating a first application example of the power storage system according to Embodiments 1 to 3. FIG. 17B is a block diagram illustrating the first application example illustrated in FIG. 17A.

In FIG. 17A, power storage device 100 is provided in a motorcycle and supplies power to the motor that drives the motorcycle. When charging power storage device 100, power storage device 100 is connected to charging device 200 via charging cable P1. Communication circuit 106 of power storage device 100 is wirelessly connected to communication circuit 203 of charging device 200. Communication circuit 206 of charging device 200 is connected to database 301 and server device 302 via the internet.

As illustrated in FIG. 17B, for example, power storage device 100 wirelessly transmits the complex impedance of each of the power storage cells and the external temperature to charging device 200. Charging device 200 estimates the internal temperature of cell stack 101 in power storage device 100 from the complex impedances and the external temperature, and determines an optimal charging current for quick charging according to the internal temperature. To determine the internal temperature, charging device 200 accesses server device 302 and sends the complex impedances and charging information (for example, the SOC). Server device 302 diagnoses the deterioration state of cell stack 101. Charging device 200 obtains deterioration information (for example, the SOH) according to the complex impedances and the charging information, and determines an optimal charging current based on the obtained deterioration information.

The internet connection by charging device 200 may be wired or wireless.

Next, a second application example of power storage system 1 will be given.

FIG. 18 is a schematic diagram illustrating a second application example of power storage system 1 according to Embodiments 1 to 3. FIG. 18 differs from FIG. 17A in that power storage device 100-rather than charging device 200-accesses database 301 and server device 302 via the internet.

The internet connection by power storage device 100 may be wired or wireless.

Next, a third application example of power storage system 1 will be given.

FIG. 19A is a schematic diagram illustrating a third application example of the power storage system according to Embodiments 1 to 3. FIG. 19B is a block diagram illustrating the third application example illustrated in FIG. 19A.

In FIG. 19A, power storage device 100 and charging device 200 are provided in an electric vehicle. The electric vehicle includes control device 400 as what is commonly referred to as an electronic control unit (ECU). Control device 400 is capable of communicating with database 301 and server device 302, and is connected to power storage device 100 and charging device 200 via communication line "com". Power storage device 100 is connected to charging device 200 via charging cable P1 and communication line "com". Charging device 200 receives a supply of power for charging from charging station 500 via charging cable P2. Communication line "com" may be part of what is commonly referred to as a wiring harness.

As illustrated in FIG. 19B, power storage device 100 transmits the complex impedance of each of the power storage cells and the external temperature over communication line "com" to control device 400. Control device 400 estimates the internal temperature of cell stack 101 in power storage device 100 from the complex impedances and the external temperature, and determines an optimal charging current for quick charging according to the internal temperature. To determine the internal temperature, control device 400 and sends the complex impedances and charging information (for example, the SOC) to server device 302. Server device 302 diagnoses the deterioration state of cell stack 101. Control device 400 obtains deterioration information (for example, the SOH) according to the complex impedances and the charging information from server device 302, determines an optimum charging current based on the obtained deterioration information, and notifies charging device 200 of the determined optimum charging current.

Although control device 400 is exemplified as estimating the internal temperature in FIG. 19B, power storage device 100 or charging device 200 may estimate the internal temperature. In such cases, power storage device 100 or charging device 200 may be connected to database 301 and server device 302 using control device 400 as a relay device.

Although power storage device 100 is exemplified as being provided in vehicles in the first to third application examples, these examples are non-limiting. For example, power storage device 100 may be applied to drones, uninterruptible power supplies, portable power supplies, etc.

Each of the elements in each of the above embodiments may be configured in the form of dedicated hardware or realized by executing a software program suitable for the element. Each of the elements may be realized by means of a program executing unit, such as a CPU or a processor, reading and executing the software program recorded on a recording medium such as a hard disk or a semiconductor memory.

### [Industrial Applicability]

The present disclosure is applicable in power storage systems including a rechargeable battery, such as in electric vehicles.

### [Reference Signs List]

- 1: power storage system
- 100: power storage device
- 101: cell stack
- 102: thermistor
- 103: current sense resistor
- 104, 104a, 104b: measurement circuit
- 105: first control unit
- 106, 107, 203, 206: communication circuit
- 110: complex impedance measuring unit
- 140: clock generation unit
- 141: frequency holding unit
- 142: reference signal generation unit
- 143, 163, 181, 188, 241, 247: DDS
- 144, 164, 182: phase shifter
- 145: voltage measuring unit
- 146: current measuring unit
- 147: temperature measuring unit
- 148, 204: alternating current excitating unit
- 149: conversion unit
- 150: integration unit
- 151: holding unit
- 152: temperature holding unit
- 153: IO unit
- 161: phase synchronization unit
- 162: reference signal generation unit
- 165: hysteresis circuit
- 166: comparator
- 167: charge pump
- 168: LPF
- 169: VCO
- 170: frequency divider
- 171: ROM
- 175: modulation unit
- 176: demodulation unit
- 177: communication clock recovery unit
- 180: reference signal generation unit
- 185: BPSK demodulator
- 186: reception data buffer
- 187: PLL
- 200: charging device
- 201: charging circuit
- 202: second control unit
- 205: clock circuit
- 210: variable current source
- 231: modulation unit
- 232: demodulation unit
- 233: communication clock generation unit
- 242: driver
- 243: transformer
- 245: transmission data buffer
- 246: bipolar converter
- 248: BPSK modulator
- 301: database
- 302: server device
- 400: control device
- 500: charging station
- B0-B5: power storage cell
- com: communication line
- P1, P2: charging cable

## Claims

1. A power storage system (1) comprising:
a cell stack (101) including a plurality of power storage cells (B0 to B5) connected in series;
a charging circuit (201) that supplies a charging current to the cell stack (101);
an alternating current excitating circuit (148) that excitates the charging current using an alternating current;
a complex impedance measuring unit (110) configured to measure a current value of the alternating current used to excitate the charging current and a voltage value of each of the plurality of power storage cells (B0 to B5), and measure a complex impedance of each of the plurality of power storage cells (B0 to B5) from the measured current value and the measured voltage value; and
a charging control unit (105, 202) configured to control the charging current based on the complex impedance,
**characterized in that**
based on the complex impedance, the charging control unit (105, 202) is configured to optimize the charging current according to deterioration information that indicates an extent of deterioration of each of the plurality of power storage cells (B0 to B5) and is obtained from an external server device (302).

2. The power storage system (1) according to claim 1,
wherein the charging control unit (105, 202) is configured to determine a value of the charging current to shorten a charging time required for a charge level of the cell stack (101) to reach a predetermined level.

3. The power storage system (1) according to claim 1 or 2, comprising:
a power storage device (100); and
a charging device (200),
wherein the power storage device (100) includes:
the cell stack (101);
the alternating current excitating circuit (148);
the complex impedance measuring unit (110); and
a first communication circuit (106) that transmits information about the complex impedance to the charging device (200), and
the charging device (200) includes:
the charging circuit (201);
the charging control unit (105, 202); and
a second communication circuit (203) that receives the information about the complex impedance from the power storage device (100).

4. The power storage system (1) according to claim 3,
wherein the power storage device (100) includes a reference signal generation circuit (180) that generates a reference frequency signal,
the alternating current excitating circuit (148) generates the alternating current synchronized with the reference frequency signal, and
the complex impedance measuring unit (110) is configured to measure the complex impedance using the reference frequency signal.

5. The power storage system (1) according to claim 1 or 2, comprising:
a power storage device (100); and
a charging device (200),
wherein the power storage device (100) includes:
the cell stack (101);
the complex impedance measuring unit (110); and
a phase synchronization circuit (161) that generates a reference frequency signal synchronized with the alternating current used to excitate the charging current,
the charging device (200) includes:
the alternating current excitating circuit (148);
the charging circuit (201); and
the charging control unit (105, 202), and
the complex impedance measuring unit (110) is configured to measure the complex impedance using the reference frequency signal.

6. The power storage system (1) according to claim 1 or 2, comprising:
a power storage device (100); and
a charging device (200),
wherein the power storage device (100) includes:
the cell stack (101);
the complex impedance measuring unit (110);
a first communication circuit (106) that transmits information about the complex impedance to the charging device (200) and receives alternating current frequency information about a frequency of the alternating current; and
a reference signal generation circuit (180) that generates a reference frequency signal from the alternating current frequency information,
the charging device (200) includes:
the alternating current excitating circuit (148);
the charging circuit (201);
the charging control unit (105, 202); and
a second communication circuit (203) that receives the information about the complex impedance from the power storage device (100) and transmits the alternating current frequency information, and
the complex impedance measuring unit (110) is configured to measure the complex impedance using the reference frequency signal.

7. The power storage system according to claim 6,
wherein the second communication circuit (203) includes:
a communication clock generation unit (233) configured to generate a communication clock signal; and
a modulation unit (231) configured to generate a communication signal that is communication data modulated using the communication clock signal,
the first communication circuit (106) includes:
a communication clock recovery unit (177) configured to recover the communication clock signal from the communication signal; and
a demodulation unit (176) configured to demodulate the communication signal using the recovered communication clock signal,
the alternating current excitating circuit (148) generates the alternating current synchronized with the communication clock signal,
the reference signal generation circuit (180) generates the reference frequency signal synchronized with the recovered communication clock signal,
the complex impedance measuring unit (110) is configured to measure the complex impedance using the reference frequency signal, and
the alternating current frequency information corresponds to a data timing of the communication signal and an edge timing of the communication clock signal.

8. The power storage system (1) according to claim 1 or 2, further comprising:
a communication circuit that transmits the complex impedance to the external server device (302), and receives, from the external server device (302), the deterioration information according to the transmitted complex impedance.

9. A charging method of charging a power storage device (100) including a cell stack (101) of a plurality of power storage cells (B0 to B5) connected in series, the charging method comprising:
excitating a charging current to be supplied to the cell stack (101) using an alternating current;
measuring a current value of the alternating current used to excitate the charging current and a voltage value of each of the plurality of power storage cells (B0 to B5);
measuring a complex impedance of each of the plurality of power storage cells (Bo to B5) from the measured current value and the measured voltage value; and
based on the complex impedance, optimizing the charging current according to deterioration information that indicates an extent of deterioration of each of the plurality of power storage cells (B0 to B5) and is obtained from an external server device (302).

## Patentansprüche

1. Stromspeichersystem (1), umfassend: einen Zellenstapel (101), der eine Vielzahl von in Reihe geschalteten Stromspeicherzellen (B0 bis B5) umfasst; eine Ladeschaltung (201), die dem Zellenstapel (101) einen Ladestrom zuführt; eine Wechselstrom-Erregungsschaltung (148), die den Ladestrom mittels eines Wechselstroms erregt; eine Kompleximpedanz-Messeinheit (110), die dazu konfiguriert ist, einen Stromwert des Wechselstroms, der zum Erregen des Ladestroms verwendet wird, und einen Spannungswert jeder der Vielzahl von Stromspeicherzellen (B0 bis B5) zu messen und eine Kompleximpedanz jeder der Vielzahl von Stromspeicherzellen (B0 bis B5) aus dem gemessenen Stromwert und dem gemessenen Spannungswert zu messen; und eine Ladesteuereinheit (105, 202), die dazu konfiguriert ist, den Ladestrom auf Grundlage der Kompleximpedanz zu steuern, **dadurch gekennzeichnet, dass** auf Grundlage der Kompleximpedanz die Ladesteuereinheit (105, 202) dazu konfiguriert ist, den Ladestrom gemäß Verschlechterungsinformationen zu optimieren, die einen Verschlechterungsgrad jeder der Vielzahl von Stromspeicherzellen (B0 bis B5) angeben und von einer externen Servervorrichtung (302) erhalten werden.

2. Stromspeichersystem (1) nach Anspruch 1, wobei die Ladesteuereinheit (105, 202) dazu konfiguriert ist, einen Wert des Ladestroms zu bestimmen, um eine Ladezeit zu verkürzen, die erforderlich ist, damit ein Ladezustand des Zellenstapels (101) ein vorbestimmtes Niveau erreicht.

3. Stromspeichersystem (1) nach Anspruch 1 oder 2, umfassend: eine Stromspeichervorrichtung (100); und eine Ladevorrichtung (200), wobei die Stromspeichervorrichtung (100) umfasst: den Zellenstapel (101); die Wechselstrom-Erregungsschaltung (148); die Kompleximpedanz-Messeinheit (110); und eine erste Kommunikationsschaltung (106), die Informationen über die Kompleximpedanz an die Ladevorrichtung (200) überträgt, und die Ladevorrichtung (200) umfasst: die Ladeschaltung (201); die Ladesteuereinheit (105, 202); und eine zweite Kommunikationsschaltung (203), die die Informationen über die Kompleximpedanz von der Stromspeichervorrichtung (100) empfängt.

4. Stromspeichersystem (1) nach Anspruch 3, wobei die Stromspeichervorrichtung (100) eine Referenzsignal-Erzeugungsschaltung (180) umfasst, die ein Referenzfrequenzsignal erzeugt, die Wechselstrom-Erregungsschaltung (148) den mit dem Referenzfrequenzsignal synchronisierten Wechselstrom erzeugt, und die Kompleximpedanz-Messeinheit (110) dazu konfiguriert ist, die Kompleximpedanz mittels des Referenzfrequenzsignals zu messen.

5. Stromspeichersystem (1) nach Anspruch 1 oder 2, umfassend: eine Stromspeichervorrichtung (100); und eine Ladevorrichtung (200), wobei die Stromspeichervorrichtung (100) umfasst: den Zellenstapel (101); die Kompleximpedanz-Messeinheit (110); und eine Phasensynchronisationsschaltung (161), die ein Referenzfrequenzsignal erzeugt, das mit dem Wechselstrom synchronisiert ist, der zum Erregen des Ladestroms verwendet wird, die Ladevorrichtung (200) umfasst: die Wechselstrom-Erregungsschaltung (148); die Ladeschaltung (201); und die Ladesteuereinheit (105, 202), und die Kompleximpedanz-Messeinheit (110) dazu konfiguriert ist, die Kompleximpedanz mittels des Referenzfrequenzsignals zu messen.

6. Stromspeichersystem (1) nach Anspruch 1 oder 2, umfassend: eine Stromspeichervorrichtung (100); und eine Ladevorrichtung (200), wobei die Stromspeichervorrichtung (100) umfasst: den Zellenstapel (101); die Kompleximpedanz-Messeinheit (110); eine erste Kommunikationsschaltung (106), die Informationen über die Kompleximpedanz an die Ladevorrichtung (200) überträgt und Wechselstromfrequenz-Informationen über eine Frequenz des Wechselstroms empfängt; und eine Referenzsignal-Erzeugungsschaltung (180), die ein Referenzfrequenzsignal aus den Wechselstromfrequenz-Informationen erzeugt, die Ladevorrichtung (200) umfasst: die Wechselstrom-Erregungsschaltung (148); die Ladeschaltung (201); die Ladesteuereinheit (105, 202); und eine zweite Kommunikationsschaltung (203), die die Informationen über die Kompleximpedanz von der Stromspeichervorrichtung (100) empfängt und die Wechselstromfrequenz-Informationen überträgt, und die Kompleximpedanz-Messeinheit (110) dazu konfiguriert ist, die Kompleximpedanz mittels des Referenzfrequenzsignals zu messen.

7. Stromspeichersystem nach Anspruch 6, wobei die zweite Kommunikationsschaltung (203) umfasst: eine Kommunikationstakt-Erzeugungseinheit (233), die dazu konfiguriert ist, ein Kommunikationstaktsignal zu erzeugen; und eine Modulationseinheit (231), die dazu konfiguriert ist, ein Kommunikationssignal zu erzeugen, das aus mittels des Kommunikationstaktsignals modulierten Kommunikationsdaten besteht, die erste Kommunikationsschaltung (106) umfasst: eine Kommunikationstakt-Rückgewinnungseinheit (177), die dazu konfiguriert ist, das Kommunikationstaktsignal aus dem Kommunikationssignal zurückzugewinnen; und eine Demodulationseinheit (176), die dazu konfiguriert ist, das Kommunikationssignal mittels des zurückgewonnenen Kommunikationstaktsignals zu demodulieren, die Wechselstrom-Erregungsschaltung (148) den mit dem Kommunikationstaktsignal synchronisierten Wechselstrom erzeugt, die Referenzsignal-Erzeugungsschaltung (180) das mit dem zurückgewonnenen Kommunikationstaktsignal synchronisierte Referenzfrequenzsignal erzeugt, die Kompleximpedanz-Messeinheit (110) dazu konfiguriert ist, die Kompleximpedanz mittels des Referenzfrequenzsignals zu messen, und die Wechselstromfrequenz-Informationen einem Datentiming des Kommunikationssignals und einem Flankentiming des Kommunikationstaktsignals entsprechen.

8. Stromspeichersystem (1) nach Anspruch 1 oder 2, ferner umfassend: eine Kommunikationsschaltung, die die Kompleximpedanz an die externe Servervorrichtung (302) überträgt und von der externen Servervorrichtung (302) die Verschlechterungsinformationen gemäß der übertragenen Kompleximpedanz empfängt.

9. Ladeverfahren zum Laden einer Stromspeichervorrichtung (100), die einen Zellenstapel (101) aus einer Vielzahl von in Reihe geschalteten Stromspeicherzellen (B0 bis B5) umfasst, wobei das Ladeverfahren umfasst: Erregen eines dem Zellenstapel (101) zuzuführenden Ladestroms mittels eines Wechselstroms; Messen eines Stromwerts des Wechselstroms, der zum Erregen des Ladestroms verwendet wird, und eines Spannungswerts jeder der Vielzahl von Stromspeicherzellen (B0 bis B5); Messen einer Kompleximpedanz jeder der Vielzahl von Stromspeicherzellen (Bo bis B5) aus dem gemessenen Stromwert und dem gemessenen Spannungswert; und auf Grundlage der Kompleximpedanz, Optimieren des Ladestroms gemäß Verschlechterungsinformationen, die einen Verschlechterungsgrad jeder der Vielzahl von Stromspeicherzellen (B0 bis B5) angeben und von einer externen Servervorrichtung (302) erhalten werden.

## Revendications

1. Système de stockage d'énergie (1) comprenant : un empilement de cellules (101) comprenant une pluralité de cellules de stockage d'énergie (B0 à B5) connectées en série ; un circuit de charge (201) qui fournit un courant de charge à l'empilement de cellules (101) ; un circuit d'excitation à courant alternatif (148) qui excite le courant de charge au moyen d'un courant alternatif ; une unité de mesure d'impédance complexe (110) configurée pour mesurer une valeur de courant du courant alternatif utilisé pour exciter le courant de charge et une valeur de tension de chacune de la pluralité de cellules de stockage d'énergie (B0 à B5), et mesurer une impédance complexe de chacune de la pluralité de cellules de stockage d'énergie (B0 à B5) à partir de la valeur de courant mesurée et de la valeur de tension mesurée ; et une unité de commande de charge (105, 202) configurée pour commander le courant de charge sur la base de l'impédance complexe, **caractérisé en ce que** sur la base de l'impédance complexe, l'unité de commande de charge (105, 202) est configurée pour optimiser le courant de charge selon des informations de détérioration qui indiquent un degré de détérioration de chacune de la pluralité de cellules de stockage d'énergie (B0 à B5) et sont obtenues d'un dispositif serveur externe (302).

2. Système de stockage d'énergie (1) selon la revendication 1, dans lequel l'unité de commande de charge (105, 202) est configurée pour déterminer une valeur du courant de charge pour raccourcir un temps de charge requis pour qu'un niveau de charge de l'empilement de cellules (101) atteigne un niveau prédéterminé.

3. Système de stockage d'énergie (1) selon la revendication 1 ou 2, comprenant : un dispositif de stockage d'énergie (100) ; et un dispositif de charge (200), dans lequel le dispositif de stockage d'énergie (100) comprend : l'empilement de cellules (101) ; le circuit d'excitation à courant alternatif (148) ; l'unité de mesure d'impédance complexe (110) ; et un premier circuit de communication (106) qui transmet des informations concernant l'impédance complexe au dispositif de charge (200), et le dispositif de charge (200) comprend : le circuit de charge (201) ; l'unité de commande de charge (105, 202) ; et un second circuit de communication (203) qui reçoit les informations concernant l'impédance complexe du dispositif de stockage d'énergie (100).

4. Système de stockage d'énergie (1) selon la revendication 3, dans lequel le dispositif de stockage d'énergie (100) comprend un circuit de génération de signal de référence (180) qui génère un signal de fréquence de référence, le circuit d'excitation à courant alternatif (148) génère le courant alternatif synchronisé avec le signal de fréquence de référence, et l'unité de mesure d'impédance complexe (110) est configurée pour mesurer l'impédance complexe au moyen du signal de fréquence de référence.

5. Système de stockage d'énergie (1) selon la revendication 1 ou 2, comprenant : un dispositif de stockage d'énergie (100) ; et un dispositif de charge (200), dans lequel le dispositif de stockage d'énergie (100) comprend : l'empilement de cellules (101) ; l'unité de mesure d'impédance complexe (110) ; et un circuit de synchronisation de phase (161) qui génère un signal de fréquence de référence synchronisé avec le courant alternatif utilisé pour exciter le courant de charge, le dispositif de charge (200) comprend : le circuit d'excitation à courant alternatif (148) ; le circuit de charge (201) ; et l'unité de commande de charge (105, 202), et l'unité de mesure d'impédance complexe (110) est configurée pour mesurer l'impédance complexe au moyen du signal de fréquence de référence.

6. Système de stockage d'énergie (1) selon la revendication 1 ou 2, comprenant : un dispositif de stockage d'énergie (100) ; et un dispositif de charge (200), dans lequel le dispositif de stockage d'énergie (100) comprend : l'empilement de cellules (101) ; l'unité de mesure d'impédance complexe (110) ; un premier circuit de communication (106) qui transmet des informations concernant l'impédance complexe au dispositif de charge (200) et reçoit des informations de fréquence de courant alternatif concernant une fréquence du courant alternatif ; et un circuit de génération de signal de référence (180) qui génère un signal de fréquence de référence à partir des informations de fréquence de courant alternatif, le dispositif de charge (200) comprend : le circuit d'excitation à courant alternatif (148) ; le circuit de charge (201) ; l'unité de commande de charge (105, 202) ; et un second circuit de communication (203) qui reçoit les informations concernant l'impédance complexe du dispositif de stockage d'énergie (100) et transmet les informations de fréquence de courant alternatif, et l'unité de mesure d'impédance complexe (110) est configurée pour mesurer l'impédance complexe au moyen du signal de fréquence de référence.

7. Système de stockage d'énergie selon la revendication 6, dans lequel le second circuit de communication (203) comprend : une unité de génération d'horloge de communication (233) configurée pour générer un signal d'horloge de communication ; et une unité de modulation (231) configurée pour générer un signal de communication qui est constitué de données de communication modulées au moyen du signal d'horloge de communication, le premier circuit de communication (106) comprend : une unité de récupération d'horloge de communication (177) configurée pour récupérer le signal d'horloge de communication à partir du signal de communication ; et une unité de démodulation (176) configurée pour démoduler le signal de communication au moyen du signal d'horloge de communication récupéré, le circuit d'excitation à courant alternatif (148) génère le courant alternatif synchronisé avec le signal d'horloge de communication, le circuit de génération de signal de référence (180) génère le signal de fréquence de référence synchronisé avec le signal d'horloge de communication récupéré, l'unité de mesure d'impédance complexe (110) est configurée pour mesurer l'impédance complexe au moyen du signal de fréquence de référence, et les informations de fréquence de courant alternatif correspondent à une synchronisation de données du signal de communication et à une synchronisation de front du signal d'horloge de communication.

8. Système de stockage d'énergie (1) selon la revendication 1 ou 2, comprenant en outre : un circuit de communication qui transmet l'impédance complexe au dispositif serveur externe (302), et reçoit, du dispositif serveur externe (302), les informations de détérioration selon l'impédance complexe transmise.

9. Procédé de charge pour charger un dispositif de stockage d'énergie (100) comprenant un empilement de cellules (101) d'une pluralité de cellules de stockage d'énergie (B0 à B5) connectées en série, le procédé de charge comprenant : l'excitation d'un courant de charge devant être fourni à l'empilement de cellules (101) au moyen d'un courant alternatif ; la mesure d'une valeur de courant du courant alternatif utilisé pour exciter le courant de charge et d'une valeur de tension de chacune de la pluralité de cellules de stockage d'énergie (B0 à B5) ; la mesure d'une impédance complexe de chacune de la pluralité de cellules de stockage d'énergie (Bo à B5) à partir de la valeur de courant mesurée et de la valeur de tension mesurée ; et sur la base de l'impédance complexe, l'optimisation du courant de charge selon des informations de détérioration qui indiquent un degré de détérioration de chacune de la pluralité de cellules de stockage d'énergie (B0 à B5) et sont obtenues d'un dispositif serveur externe (302).
